# EUROPEAN PATENT APPLICATION

(11) **EP 4 730 604 A1**
(43) Date of publication of application: **22.04.2026**
(21) Application number: 25206828.3
(22) Date of filing: 06.10.2025
(51) Int. Cl.: H02J 7/60, H01M 10/42, H02J 7/70

(54) **PROTECTION CIRCUIT MODULE AND BATTERY ASSEMBLY INCLUDING THE SAME**

(30) Priority: 17.10.2024 KR 20240141736
(71) Applicant: SAMSUNG SDI CO., LTD., Yongin-si, Gyeonggi-do 17084 (KR)
(72) Inventor: LEE, Woojin, 17084 Yongin-Si, Gyeonggi-do (KR)
(74) Representative: Gulde & Partner

(57) **Abstract**

The present disclosure relates to a protection circuit module and a battery assembly including the same. The protection circuit module may include a first substrate on which a first-first connection member connected to a first electrode terminal of a battery cell and a second connection member connected to a second electrode terminal of the battery cell are located, and a second substrate connected to the first substrate and on which a first-second connection member is located, wherein the second substrate may be electrically connected to the first-first connection member from among the first-first connection member and the second connection member.

## Description

### BACKGROUND

### 1. Field

The present disclosure relates to a protection circuit module and a battery assembly including the same.

### 2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

The operational voltage range and battery capacity of secondary batteries may be determined depending on the positive electrode, the negative electrode, and the electrolyte. Charging and discharging significantly outside the allowable range may damage the battery, resulting in permanent functional impairment or even fire. A protection circuit module (PCM) may be a safety device that prevents the battery from igniting or exploding by short-circuiting the circuit to prevent further current flow in a case where the internal temperature of the battery rises to a high temperature or the voltage of the battery rises due to overcharging, etc. Through the PCM, the battery may be protected by blocking overcharge, overdischarge, overcurrent, etc. in advance during the use of electronic products with batteries mounted thereon.

The PCM may be connected to a positive electrode terminal and a negative electrode terminal of the battery and may be connected to a positive electrode external terminal and a negative electrode external terminal. Therefore, the PCM needs to include a circuit for connecting a positive electrode-related battery terminal and an external terminal and a circuit for connecting a negative electrode-related battery terminal and an external terminal. In order to configure a circuit related to two polarities within a limited substrate, the PCM may to be formed with a narrow width. Accordingly, current flowing for charging and discharging the battery cell is limited to a certain amount or less, and high-speed charging and discharging of the battery cell may be difficult.

The above information disclosed in this Background section is for enhancement of understanding of the background of the present disclosure, and therefore, it may contain information that does not constitute related (or prior) art.

### SUMMARY

To solve the problems described above, the present disclosure provides a protection circuit module and a battery assembly including the same.

These and other aspects and features of the present disclosure will be described in or will be apparent from the following description of embodiments of the present disclosure.

According to one or more embodiments of the present disclosure, a protection circuit module includes a first substrate on which a first-first connection member connected to a first electrode terminal of a battery cell and a second connection member connected to a second electrode terminal of the battery cell are located, and a second substrate connected to the first substrate and on which a first-second connection member is located, wherein the second substrate is electrically connected to the first-first connection member from among the first-first connection member and the second connection member.

According to one or more embodiments, the second substrate may be a flexible printed circuit board (FPCB).

According to one or more embodiments, the protection circuit module may further include a connection circuit configured to connect the first-first connection member and the first-second connection member.

According to one or more embodiments, the connection circuit configured to connect the first-first connection member and the first-second connection member may be located on the first substrate and the second substrate.

According to one or more embodiments, one end of opposite ends of the second substrate may be connected to the first substrate, and the first-second connection member may be located at another end thereof.

According to one or more embodiments, the first-first connection member may be connected to the first electrode terminal of the battery cell, and the first-second connection member, electrically connected to the first-first connection member may be connected to an external terminal having a same polarity as the first electrode terminal.

According to one or more embodiments, the protection circuit module may further include a protection circuit located on the first substrate, wherein the protection circuit may be electrically connected to the first-first connection member and the second connection member and may be located on the first substrate.

According to one or more embodiments, the protection circuit module may further include a connection circuit configured to connect the first-first connection member and the first-second connection member and including a relay and an electric resistor located between the first-first connection member and the first-second connection member, wherein the protection circuit may be configured to control the relay and a sense current of the electric resistor.

According to one or more embodiments, the protection circuit module may further include a connection circuit configured to connect the first-first connection member and the first-second connection member and including a first relay, a second relay, a first electric resistor, and a second electric resistor located between the first-first connection member and the first-second connection member, wherein the protection circuit may include a first protection circuit and a second protection circuit, the first protection circuit may be configured to control the first relay and sense a current of the first electric resistor, and the second protection circuit may be configured to control the second relay and sense a current of the second electric resistor.

According to one or more embodiments of the present disclosure, a battery assembly includes a battery cell including an electrode assembly including a first electrode and a second electrode, a first electrode terminal connected to the first electrode, a second electrode terminal connected to the second electrode, and a case configured to accommodate the electrode assembly and connected to the second electrode, and a protection circuit module including a first substrate and a second substrate connected to the first substrate, wherein a first-first connection member connected to the first electrode terminal and a second connection member connected to the second electrode terminal is located on the first substrate, and the second substrate is electrically connected to the first-first connection member from among the first-first connection member and the second connection member.

According to one or more embodiments, an external terminal having a different polarity from the first electrode may be electrically connected to the case.

According to one or more embodiments, the protection circuit module may further include connection members located on a surface of the case and comprises a conductive material.

According to one or more embodiments, the connection members may be formed integrally with the case.

According to one or more embodiments, the connection member may be located on other surface of the case except for one surface of the case on which the first electrode terminal is located.

According to one or more embodiments, the case may include a plurality of side surfaces, and the connection members may be respectively located on at least one of the side surfaces.

According to one or more embodiments, the case may include a plurality of corners, and the connection members may be respectively located on at least one of the corners.

According to one or more embodiments, the battery assembly may further include an insulating film around at least a part of the remaining area of the surface of the case except for an area where the connection member, the first electrode terminal, and the second electrode terminal are located.

According to one or more embodiments, the second substrate may be a flexible printed circuit board (FPCB).

According to one or more embodiments, the protection circuit module may further include a protection circuit on the first substrate, and the protection circuit may be electrically connected to the first-first connection member and the second connection member and may be configured to receive power from the battery cell.

According to one or more embodiments, an electronic device including the battery assembly may be provided.

According to one or more embodiments of the present disclosure, the width of the connection circuit located on the second substrate of the protection circuit module may be formed relatively large. Accordingly, the amount of the current passing through the connection circuit may be relatively increased. The increased amount of current facilitates rapid charging and discharging of battery cells.

According to one or more embodiments of the present disclosure, the protection circuit module may include the protection circuits. Accordingly, even in a case where a problem occurs in a component associated with one of the protection circuits, the function of the protection circuit may be performed by using another protection circuit. That is, the protection circuit module may doubly protect the battery cell through the protection circuits.

According to one or more embodiments of the present disclosure, an electrical path may be formed in a certain structure for accommodating the battery assemblies without a configuration for forming a separate electrical path.

However, aspects and features of the present disclosure are not limited to those described above, and other aspects and features not mentioned will be clearly understood by a person skilled in the art from the detailed description, described below.

### BRIEF DESCRIPTION OF DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 illustrates a battery cell according to one or more embodiments of the present disclosure;
FIG. 2 illustrates a battery cell and a protection circuit module of a battery assembly according to one or more embodiments of the present disclosure;
FIG. 3 illustrates one surface of a battery cell and a protection circuit module of a battery assembly according to one or more embodiments of the present disclosure;
FIG. 4 illustrates a circuit diagram of a protection circuit module according to one or more embodiments of the present disclosure;
FIG. 5 illustrates one surface of a battery assembly according to one or more embodiments of the present disclosure;
FIG. 6 illustrates one surface of a battery assembly according to one or more embodiments of the present disclosure;
FIG. 7 illustrates one surface of a battery assembly according to one or more embodiments of the present disclosure;
FIG. 8 illustrates one surface of a battery assembly according to one or more embodiments of the present disclosure; and
FIG. 9 illustrates a configuration in which a plurality of battery assemblies are connected in parallel according to one or more embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

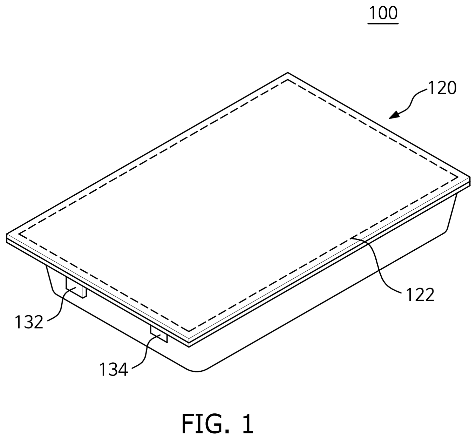

FIG. 1 illustrates a battery cell 100 according to one or more embodiments of the present disclosure. The battery cell 100 may include an electrode assembly and a case 120. The electrode assembly may include a first electrode, a second electrode, and a separator, which are formed in a thin plate or film shape. The separator may be positioned between the first electrode and the second electrode. The electrode assembly may be configured by winding or stacking the first electrode, the second electrode, and the separator. In one or more embodiments, the electrode assembly may have a stack type or other shapes.

The first electrode may be configured by positioning a first mixture portion on at least a part of a first substrate. A first electrode tab may extend outward from a first uncoated portion of the first substrate where the first mixture portion is not positioned. The first electrode tab may be electrically connected to a first electrode terminal 134. However, the present disclosure is limited thereto, and the first electrode tab may be exposed to the outside of the case 120 and function as the first electrode terminal 134.

The second electrode may be configured by positioning a second mixture portion on at least a part of a second substrate. A second electrode tab may extend outward from a second uncoated portion of the second substrate where the second mixture portion is not positioned. The second electrode tab may be electrically connected to a second electrode terminal 132. However, the present disclosure is limited thereto, and the second electrode tab may be exposed to the outside of the case 120 and function as the second electrode terminal 132.

In one or more embodiments, the first electrode terminal 134 and the second electrode terminal 132 may be positioned on one surface of the case 120. For example, the first electrode terminal 134 and the second electrode terminal 132 may be formed to be exposed through a through hole formed in one surface of the case 120. However, the present disclosure is not limited thereto, and the first electrode terminal 134 and the second electrode terminal 132 may have various structures that are electrically connectable to components (e.g., a connection member of a protection circuit module to be described below) positioned outside the case 120.

The first electrode may function as a positive electrode. In this case, the first substrate may include (e.g., may be composed of), for example, aluminum foil, and the first active material layer may include, for example, a transition metal oxide. The second electrode may function as a negative electrode. In this case, the second substrate may include (e.g., may be composed of), for example, copper foil and/or nickel foil, and the second active material layer may include, for example, graphite.

The separator may function to prevent a short circuit between the first electrode and the second electrode while allowing movement of lithium ions. The separator may be composed of, for example, polyethylene film, polypropylene film, polyethylene-polypropylene film, and/or the like, but the present disclosure is not limited thereto. In one or more embodiments, the separator may be positioned between the first electrode and the second electrode. In one or more embodiments, the separator may be positioned between the first mixture portion of the first electrode and the second mixture portion of the second electrode.

The case 120 may accommodate the electrode assembly and the electrolyte and may configure the outer shape of the secondary battery. In a case where the electrode assembly is a wound stack, the winding axis may be parallel to the longitudinal direction of the case. For example, the case 120 may include an accommodation portion that accommodates the electrode assembly and a cover plate that seals the accommodation portion. At this time, the case 120 may include a joining line 122 for joining the accommodation portion and the cover plate. The joining line 122 may be formed by welding the accommodation portion and the cover plate along the edge of the case 120. In one or more embodiments, the case 120 may be made of a metal, such as stainless steel (SUS), aluminum, an aluminum alloy, and/or nickel-plated steel. According to one or more embodiments, the accommodation portion and the cover plate of the case 120 may be made of stainless steel (SUS).

In one or more embodiments, a film portion may be positioned around the first electrode terminal 134. The film portion may include an insulating material to insulate between the first electrode terminal 134 and the case 120. Due to this, advantageously the film portion may prevent a short circuit between the first electrode terminal 134 and the case 120.

In one or more embodiments, the film portion may not be positioned around the second electrode terminal 132. Due to this, the second electrode terminal 132 and the case 120 may be connected, and thus, the second electrode may be electrically connected to the case 120. At this time, the case 120 may include a conductive material. Due to this, the case 120 may be connected to an external terminal having the same polarity as the second electrode, and the external terminal may be electrically connected to the second electrode.

In one or more embodiments, the film portion may be positioned around the second electrode terminal 132 rather than around the first electrode terminal 134. In this case, the first electrode terminal 134 may be electrically connected to the case 120, and the second electrode terminal 132 may not be electrically connected to the case 120. However, the electrical connection between the electrode terminal (e.g., the first electrode terminal 134 or the second electrode terminal 132) and the case 120 may not be determined solely by the film portion. For example, the component connected to the electrode (e.g., the first electrode tab connected to the first electrode or the second electrode tab connected to the second electrode) inside the case 120 may be connected to the case 120.

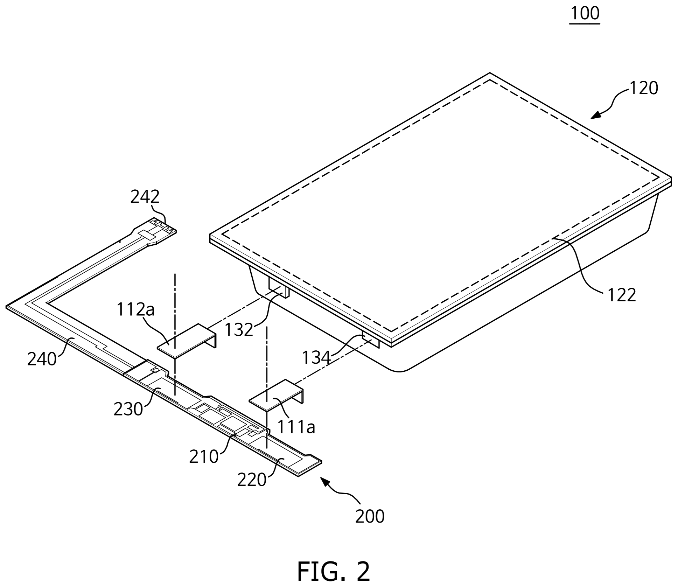

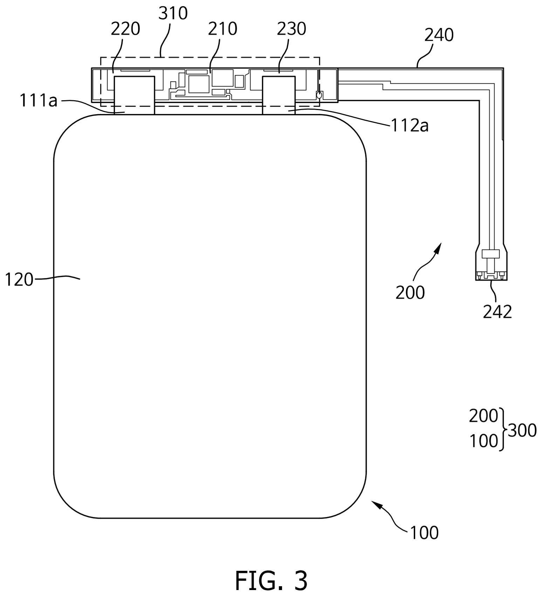

FIG. 2 illustrates a battery cell 100 and a protection circuit module 200 of a battery assembly according to one or more embodiments of the present disclosure. FIG. 3 illustrates a battery cell 100 and a protection circuit module 200 of a battery assembly 300 according to one or more embodiments of the present disclosure. The protection circuit module 200 may be electrically connected to the battery cell 100 and may perform the function of preventing overcharge, overdischarge, and overcurrent of the battery cell 100. In one or more embodiments, the protection circuit module 200 may be electrically connected to an electrode assembly accommodated in a case 120 to perform a protection function for the battery cell 100.

The protection circuit module 200 may include a first substrate 210 on which a 1_1 connection member 220 and a second connection member 230 are positioned. The 1_1 connection member 220 may be electrically connected to a first electrode terminal 134 of the battery cell 100, and the second connection member 230 may be electrically connected to a second electrode terminal 132 of the battery cell 100. Due to this, the protection circuit module 200 may be electrically connected to a first electrode and a second electrode of the electrode assembly accommodated in the case 120.

Referring to FIG. 2, the 1_1 connection member 220 may be connected to a first connection tab 111a, and the first connection tab 111a may be connected to the first electrode terminal 134. In one or more embodiments, the second connection member 230 may be connected to a second connection tab 112a, and the second connection tab 112a may be connected to the second electrode terminal 132. In this case, the first connection tab 111a and/or the second connection tab 112a may be bent and connected to another component (e.g., an electrode terminal or a connection member). Due to this, the 1_1 connection member 220 may be electrically connected to the first electrode terminal 134 of the battery cell 100, and the second connection member 230 may be electrically connected to the second electrode terminal 132 of the battery cell 100. However, the present disclosure is not limited thereto, and the 1_1 connection member 220 may be connected to (e.g., directly connected to) the first electrode terminal 134 and the second connection member 230 may be connected to (e.g., directly connected to) the second electrode terminal 132. Hereinafter, the description is based on the assumption that the 1_1 connection member 220 is connected to the first connection tab 111a and the second connection member 230 is connected to the second connection tab 112a.

The protection circuit module 200 may include a second substrate 240 connected to the first substrate 210. A 1_2 connection member 242 may be positioned on the second substrate 240. The second substrate 240 may be electrically connected to the 1_1 connection member 220 from among the 1_1 connection members 220 and/or the second connection members 230. For example, the 1_2 connection member 242 of the second substrate 240 may be electrically connected only to the 1_1 connection member 220 from among the 1_1 connection members 220 and/or the second connection members 230 disposed on the first substrate 210.

The protection circuit module 200 may include a connection circuit that connects the 1_1 connection member 220 and the 1_2 connection member 242. For example, the connection circuit that connects the 1_1 connection member 220 and the 1_2 connection member 242 may be positioned on the first substrate 210 and the second substrate 240. In one or more other embodiments, the connection circuit that connects the 1_1 connection member 220 and the second connection member 230 may be positioned only on the first substrate 210. A circuit connected to the second connection member 230 may not be positioned on the second substrate 240.

Referring to FIG. 3, the second connection member 230 is shown as being positioned between the 1_1 connection member 220 and the 1_2 connection member 242 in the protection circuit module 200, but the present disclosure is not limited thereto. For example, the 1_1 connection member 220 may be positioned between the 1_2 connection member 242 and the second connection member 230. In one or more embodiments, the positions of the 1_1 connection member 220 and the second connection member 230 shown in FIG. 3 may be interchanged. In this case, the electrical connection relationship between the component included in the first substrate 210 and the component included in the second substrate 240 may be the same.

In one or more embodiments, the second substrate 240 may correspond to a flexible printed circuit board (FPCB), thus advantageously allowing a space efficient installation. In one or more embodiments, referring to FIG. 2, one of opposite ends of the second substrate 240 may be connected to the first substrate 210, and the 1_2 connection member 242 may be positioned at the other end thereof. However, the position of the 1_2 connection member 242 and the connection portion of the first substrate 210 are not limited thereto.

In one or more embodiments, the protection circuit module 200 may include components mounted on the substrate (e.g., the first substrate 210 and/or the second substrate 240). The components may be spaced (e.g., spaced apart) from the connection member (e.g., the 1_1 connection member 220, the second connection member 230, the 1_2 connection member 242, etc.). Components such as relays, electric resistors, capacitors, and positive temperature coefficient (PTC) thermistors may be mounted on the substrate. Referring to FIG. 2, the connection member and the components on the first substrate 210 are shown as having an approximately rectangular parallelepiped shape, but the position, shape, etc. of the component are not limited thereto.

The relays may turn on or off some of the circuits electrically connected to the battery cell 100 to supply or cut off power to the circuit. The electric resistors may be used to measure current. The capacitors may protect the components from abnormal voltage or static electricity and cancel noise. The components positioned on the substrate are not limited thereto, and components necessary to perform the function of preventing overcharge, overdischarge, and overcurrent of the battery cell 100 may be mounted on the substrate.

Various circuits may be positioned on the substrate. For example, the protection circuit or the connection circuit may be positioned on the substrate. The protection circuit may detect overcharge, overdischarge, and overcurrent conditions of the battery cells. The protection circuit may be electrically connected to a positive terminal of the battery cell. The connection circuit corresponds to a circuit for connection between connection members. For example, the connection circuit may include electric resistors and relays.

In one or more embodiments, the connection member may include a conductive material through which current may flow for electrical connection. For example, the connection member may include (e.g., may be made of) nickel. In one or more embodiments, the connection between the connection member and the external terminal and/or the connection between the connection member and the electrode terminal (e.g., the first connection tab 111a and/or the second connection tab 112a) may be made by contact, latching, soldering, resistance welding, laser welding, projection welding, and/or the like.

Referring to FIG. 3, in one or more embodiments, the battery assembly 300 may include a battery cell 100 and a protection circuit module 200. For example, a 1_1 connection member 220 may be connected to a first connection tab 111a, and a first connection tab 111a may be connected to a first electrode terminal 134. In one or more embodiments, a second connection member 230 may be connected to a second connection tab 112a, and a second connection tab 112a may be connected to a second electrode terminal 132. The protection circuit module 200 may be electrically connected to an electrode terminal and positioned on a corresponding surface of a case 120. However, the arrangement of the electrode terminal and the protection circuit module 200 is not limited thereto, and various arrangements of the electrode terminal and the protection circuit module 200 may be applied as long as the electrical connection relationship between the electrode terminal and the connection member may be maintained.

The battery assembly 300 may be connected to an external terminal. The protection circuit module 200 may be electrically connected to a first external terminal having the same polarity as the first electrode of the electrode assembly. For example, a 1_2 connection member 242 electrically connected to the 1_1 connection member 220 may be connected to a first external terminal having the same polarity as the first electrode. By connecting the 1_2 connection member 242 of the protection circuit module 200 and the first external terminal, the protection circuit module 200 may be connected to the first external terminal. The first external terminal may be electrically connected to the first electrode through the 1_2 connection member 242 and 1_1 connection member 220 connected to the 1_2 connection member 242.

The case 120 of the battery cell 100 may be connected to a second external terminal. For example, the case 120 may be electrically connected to the second electrode of the electrode assembly. The case 120 may be electrically connected to the second external terminal having the same polarity as the second electrode, and the second electrode of the electrode assembly may be electrically connected to the second external terminal. By connecting a connection member positioned on the surface of the case 120 and the second external terminal, the second electrode and the second external terminal may be electrically connected to each other.

According to one or more embodiments, in some areas of the protection circuit module 200, a circuit for electrically connecting the second connection tab 112a and the second electrode may not be required. Some areas of the protection circuit module 200 may correspond to a flexible substrate or a second substrate 240.

For example, the second substrate 240 of the protection circuit module 200 may not include a connection member and/or the like for connection to the second external terminal. The second substrate 240 of the protection circuit module 200 may not include a circuit for connecting the second external terminal and the second connection member 230. Instead, the second substrate 240 of the protection circuit module 200 may include a connection circuit to which a 1_1 connection member 220 electrically connected to the first electrode and a 1_2 connection member 242 electrically connected to the first external terminal are connected. Because the second substrate 240 does not require a circuit for electrically connecting the second external terminal and the second electrode, the space where the circuit is to be positioned may advantageously be utilized as a space for a connection circuit, thus achieving a high space efficiency. In one or more embodiments, the width of the connection circuit may be relatively increased. Accordingly, the amount of the current passing through the connection circuit may be increased.

The first external terminal associated with the first electrode may be electrically connected to the first electrode of the electrode assembly through the protection circuit module 200, and the second external terminal associated with the second electrode may be electrically connected to the second electrode of the electrode assembly through the case 120. An electronic device including the battery assembly may be connected to the first external terminal and the second external terminal, and the electronic device may include an electrical path connected to the battery cell 100. The electronic device may be supplied with a power from the battery cell 100 or may be supplied with an external power to charge the battery cell 100.

The electronic device may include an operation unit that performs a set operation, a housing that accommodates the operation unit therein, and a battery cell 100 that is fixed inside the housing and configured to supply power to the operation unit. The protection circuit module may be connected to the battery cell 100.

The operation unit may include various operation units that are supplied with power and driven by electrical energy. For example, the operation unit may include an application processor (AP), a central process unit (CPU), and a motor control unit (MCU) of an electric vehicle. For example, a printed circuit board (PCB) having a signal transmission wiring may be positioned inside the housing, and an operation unit may be mounted on the printed circuit board (PCB) and electrically connected to other components of the electronic device. The housing may accommodate the operation unit and the battery cells therein and provide the exterior of the electronic device. The housing may support the operation unit and the battery cells positioned therein, may protect the operation unit and the battery cells from external impact, and may be provided in various structures.

The battery cells may be fixed inside the housing to provide stable power to the operation unit. For example, the battery cells may be positioned in a power area inside the housing and connected to power terminals of the printed circuit board (PCB). Accordingly, the operation unit may be driven by using the electric energy stored in the battery cell. In particular, the battery cell may be provided as a SUS can-type battery in which the electrode assembly is positioned inside the SUS can made of stainless steel.

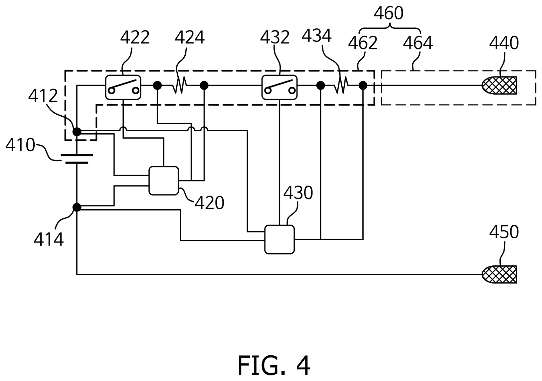

In one or more embodiments, the protection circuit module 200 may include a protection circuit positioned on the first substrate 210. The protection circuit may be electrically connected to the 1_1 connection member 220 and the second connection member 230. The protection circuit may be supplied with power from the battery cell 100. The protection circuit may sense and prevent overcharge, overdischarge, and overcurrent of the connection circuit to which the 1_1 connection member 220 and the 1_2 connection member 242 are connected. A detailed structure and function of the protection circuit are described with reference to FIG. 4.

Referring to FIG. 3, the first substrate 210 of the protection circuit module 200 may have a protection circuit and components positioned in a protection circuit area 310. The protection circuit and the components may be spaced (e.g., spaced apart) from the 1_1 connection member 220 and the second connection member 230. For example, the protection circuit may be an integrated circuit (IC) and the components may include relays, electric resistors, etc.

As described above, the width of the connection circuit disposed on the second substrate of the protection circuit module 200 may be formed relatively large. Accordingly, the amount of the current passing through the connection circuit may be relatively increased. The increased amount of current facilitates rapid charging and discharging of battery cells 100.

FIG. 4 illustrates a circuit diagram of a protection circuit module according to one or more embodiments of the present disclosure. In one or more embodiments, a positive electrode of a battery cell 410 may be electrically connected to a first external terminal 440. A negative electrode of the battery cell 410 may be connected to a second external terminal 450. A first electrode of an electrode assembly included in the battery cell 410 may correspond to a positive electrode, and a second electrode of the electrode assembly included in the battery cell 410 may correspond to a negative electrode, or vice versa. For convenience of description, it is assumed that the first electrode of the electrode assembly included in the battery cell 410 corresponds to the positive electrode and the second electrode of the electrode assembly included in the battery cell 410 corresponds to the negative electrode.

In one or more embodiments, the positive electrode of the battery cell 410 may be connected to a first point 412, and the negative electrode of the battery cell 410 may be connected to a second point 414. The first point 412 may correspond to a point where the first connection tab of the battery cell 410 (e.g., the first connection tab 111a of FIGS. 2 and 3) and the 1_1 connection member of the protection circuit module (e.g., the 1_1 connection member 220 of FIGS. 2 and 3) are connected. The second point 414 may correspond to a point where the second connection tab of the battery cell 410 (e.g., the second connection tab 112a of FIGS. 2 and 3) and the second connection member of the protection circuit module (e.g., the second connection member 230 of FIGS. 2 and 3) are connected.

The protection circuit module may include a first protection circuit 420 and a second protection circuit 430. The first protection circuit 420 and the second protection circuit 430 may be positioned on the first substrate. In one or more embodiments, the first protection circuit 420 may be electrically connected to the battery cell 410 through the first point 412 and the second point 414. Due to this, the first protection circuit 420 may be supplied with power from the battery cell 410. Similarly, the second protection circuit 430 may be electrically connected to the battery cell 410 through the first point 412 and the second point 414. Due to this, the second protection circuit 430 may be supplied with power from the battery cell 410.

The protection circuit module may include a connection circuit 460 positioned on the first substrate and the second substrate. In one or more embodiments, the connection circuit 460 may connect the 1_1 connection member and the 1_2 connection member connected to the first electrode terminal of the battery cell 410. Referring to FIG. 4, the connection circuit 460 may correspond to a circuit connected to the positive electrode of the battery cell 410 and the first external terminal 440. The connection circuit 460 may include a first partial connection circuit 462 positioned on the first substrate and a second partial connection circuit 464 positioned on the second substrate.

In one or more embodiments, the first partial connection circuit 462 may include relays 422 and 432 and electric resistors 424 and 434. Referring to FIG. 4, the first partial connection circuit 462 may include a circuit in which the first relay 422, the first electric resistor 424, the second relay 432, and the second electric resistor 434 are sequentially positioned. The first protection circuit 420 may control the first relay 422. The first protection circuit 420 may sense the current flowing through the first electric resistor 424. The second protection circuit 430 may control the second relay 432. The second protection circuit 430 may sense the current flowing through the second electric resistor 434.

The protection circuits 420 and 430 may prevent overcharge, overdischarge, overcurrent, etc. of the battery cell 410. For example, the first protection circuit 420 may sense the current flowing through the first electric resistor 424 (e.g., a first current), and the first protection circuit 420 may control the first relay 422 based on the sensed first current value. For example, the first protection circuit 420 may turn off the first relay 422 in response to the sensed first current value equal to or greater than a first threshold current value (e.g., a certain first threshold current value). Due to the turned-off first relay 422, charging and discharging of the battery cell 410 may be blocked. In one or more embodiments, the second protection circuit 430 may sense the current flowing through the second electric resistor 434 (e.g., a second current), and the second protection circuit 430 may control the second relay 432 based on the sensed second current value. For example, the second protection circuit 430 may turn off the second relay 432 in response to the sensed second current value equal to or greater than a second threshold current value (e.g., a certain second threshold current value). Due to the turned-off second relay 432, charging and discharging of the battery cell 410 may be blocked. However, the functions of the protection circuits 420 and 430 are not limited thereto and may obtain information about the battery cell 410 together with a component electrically connected to the battery cell 410, detect the state of the battery cell 410, and control the electrical connection of the battery cell 410.

In one or more embodiments, the negative electrode of the battery cell 410 may be electrically connected to the second external terminal 450. For example, the case of the battery cell 410 may be electrically connected to the negative electrode of the electrode assembly. The second external terminal 450 connected to the case may be electrically connected to the negative electrode of the electrode assembly. The protection circuit module may not include a circuit connected to the second external terminal 450 and the negative electrode of the battery cell 410.

As described above, the protection circuit module may prevent overcharge, overdischarge, overcurrent, etc. of the battery cell 410 through components (e.g., the relays 422 and 432 and the electric resistors 424 and 434). In one or more embodiments, because the protection circuit module includes the protection circuits 420 and 430, even in a case where a problem occurs in one protection circuit and/or a component associated with one protection circuit, the function of the protection circuit may be performed by using another protection circuit and a component associated with the other protection circuit, thus intentionally accepting higher production cost for the redundancy achieved by the two protection circuits 420 and 430. That is, advantageously the protection circuit module may doubly protect the battery cell 410 through the protection circuits 420 and 430.

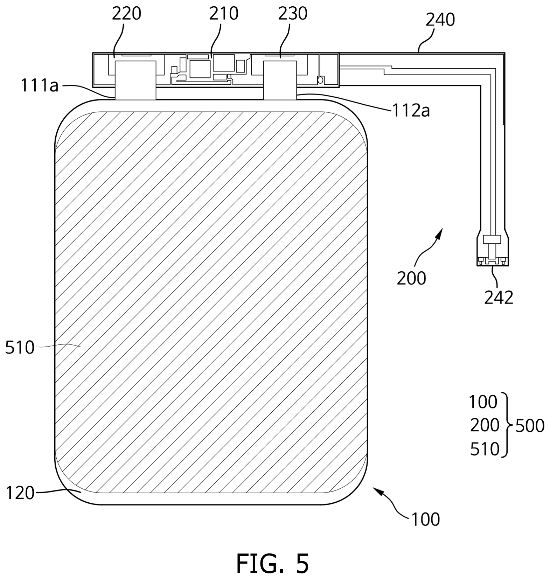

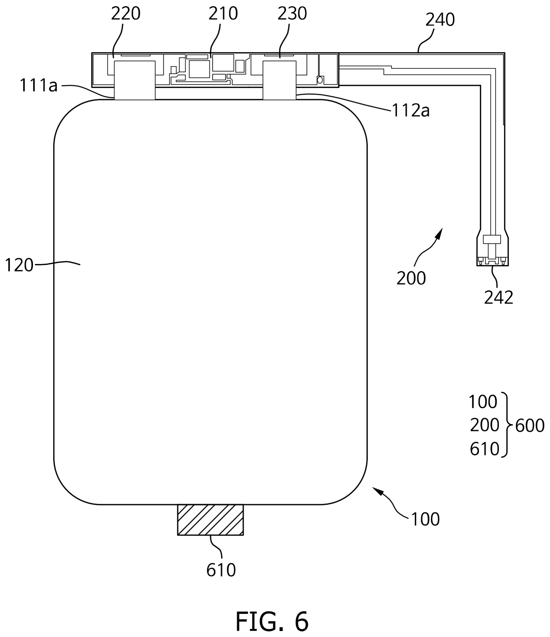

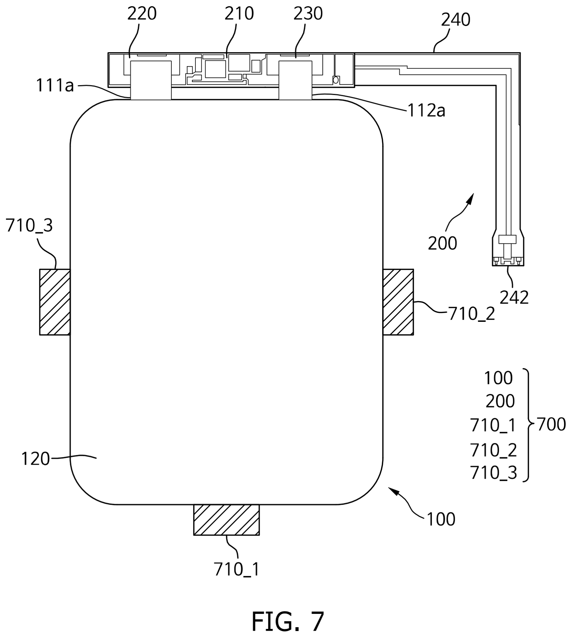

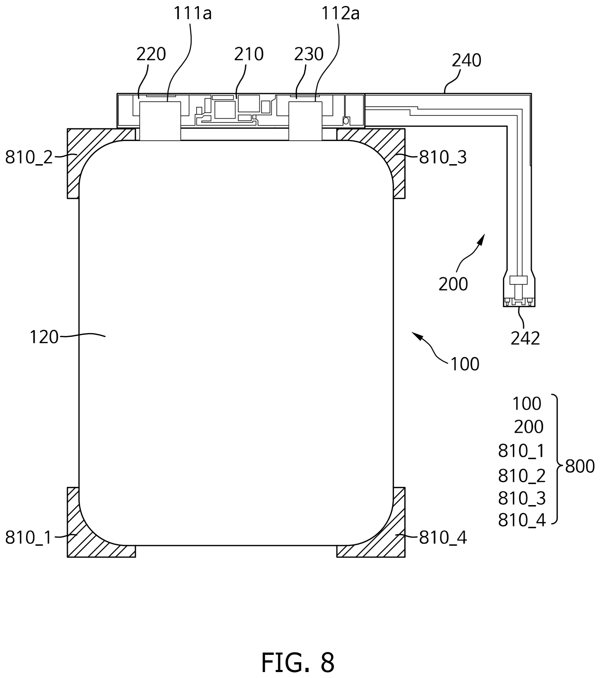

FIG. 5 illustrates one surface of a battery assembly 500 according to one or more embodiments of the present disclosure. FIG. 6 illustrates one surface of a battery assembly 600 according to one or more embodiments of the present disclosure. FIG. 7 illustrates one surface of a battery assembly 700 according to one or more embodiments of the present disclosure. FIG. 8 illustrates one surface of a battery assembly 800 according to one or more embodiments of the present disclosure. In FIGS. 5 - 9, the battery cell 100 and the protection circuit module 200 may be understood through the description provided above.

Referring to FIG. 5, in one or more embodiments, the battery assembly 500 may further include an insulating film 510 positioned on the surface of the case 120 of the battery cell 100. The insulating film 510 may electrically isolate other objects that may come into contact with the surface of the case 120 that have polarity (e.g., positive or negative).

One surface of the insulating film 510 may have adhesive strength. The corresponding surface of the insulating film 510 may be attached to the surface of the case 120. Due to this, the insulating film 510 may be stably fixed on the case 120.

In one or more embodiments, the insulating film 510 may be positioned on at least a part of the surface of the case 120. For example, the insulating film 510 may be around (e.g., may surround) the remaining area of the surface of the case 120 except for the area where the first electrode terminal and the second electrode terminal are formed. In a case where a connection member is positioned on the surface of the case 120, the insulating film 50 may be around (e.g., may surround) the remaining area except for the area where the connection member is formed. The connection member is described in detail with reference to FIGS. 6 -9.

As described above, by positioning the insulating film 510 on the surface of the case 120, a short circuit that may occur due to contact between the case 120 and other object having polarity may be prevented. The insulating film 510 does not cover the area where the electrode terminal and the connection member are formed, and thus, the electrical connection between the battery cell 100 and the protection circuit module and the electrical connection between the battery cell 100 and the external terminal may be maintained.

Referring to FIG. 6, in one or more embodiments, the battery assembly 600 may further include a connection member 610 positioned on the surface of the case 120. The connection member may include a conductive material. The case 120 and the second electrode of the electrode assembly may be connected and the case 120 and the connection member 610 may be connected, and thus, the connection member 610 may also be electrically connected to the second electrode. Accordingly, the connection member 610 may have the same polarity as the second electrode.

In one or more embodiments, the connection member 610 may be positioned on one surface of the case 120. For example, in a case where the case 120 has a plurality of surfaces, the connection member 610 may be positioned on at least one of the surfaces of the case 120. As another example, the connection member 610 may be positioned on at least one of the surfaces other than the surface on which the electrode terminals (e.g., the first electrode terminal and the second electrode terminal) are formed.

In one or more embodiments, the connection member 610 may be joined to the case 120 by welding. In one or more embodiments, the connection member 610 may be joined to the case 120 by a screw, thus enabling a cost efficient and reversable connection. In one or more embodiments, the connection member 610 may be formed integrally with the case 120. The structure and connection method of the connection member 610 are not limited thereto, and any structural that is connectable to the external terminal on the surface of the case 120 may be used.

In one or more embodiments, the case 120 and/or the connection member 610 may be electrically connected to the external terminal having a different polarity than the first electrode. For example, the second electrode having a different polarity from the first electrode and the second external terminal having the same polarity as the first electrode may be connected to the case 120 and/or the connection member 610. Due to this, the second external terminal may be electrically connected to the second electrode. That is, the second external terminal may be electrically connected to the second electrode of the electrode assembly without passing through the protection circuit module 200.

Because the connection member 610 is positioned on the surface of the case 120 and has a structure that protrudes relatively from the outer shape of the case 120, electrical connection between the external terminal and the case 120 having electrical polarity may be facilitated.

Referring to FIG. 7, a battery assembly 700 may include a plurality of connection members 710_1 to 710_3. The case 120 may include a plurality of side surfaces. Each of the connection members 710_1 to 710_3 may be respectively positioned on at least one of the side surfaces of the case 120. In one or more embodiments, one or more connection members may be respectively disposed on at least one of the side surfaces of the case 120. For example, the connection members 710_1 to 710_3 may be positioned on the side surfaces other than the side surface on which the electrode terminal is formed from among the side surfaces.

Referring to FIG. 8, a battery assembly 800 may include a plurality of connection members 810_1 to 810_4. The case 120 may include a plurality of corners. Each of the connection members 810_1 to 810_4 may be respectively positioned on at least one of the corners of the case 120. The shape of the connection member may be formed to correspond to the corner of the case 120.

The shape and appearance of the connection member are not limited to those shown in FIGS. 6 - 8. As long as the connector is positioned on the surface of the case and may be connected to the external terminal, various shapes and forms of the connection member may be utilized.

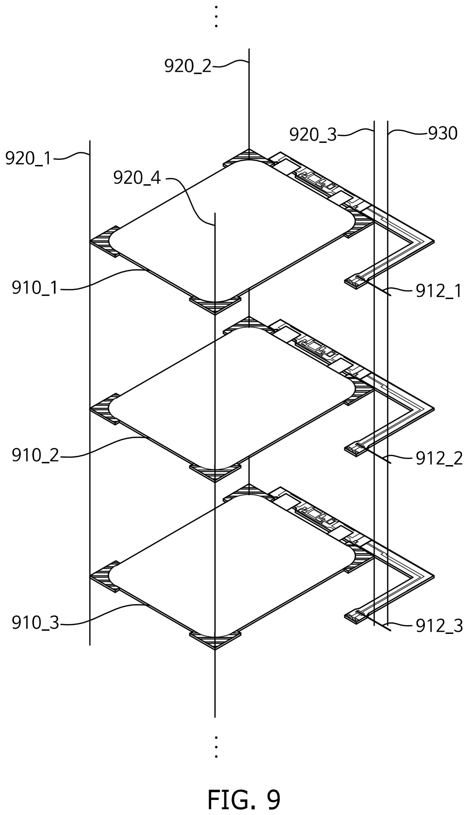

As described above with reference to FIGS. 7 and 8, a plurality of connection members may be positioned on the surface of the case 120. This makes it easy for the external terminals to be electrically connected to the case. In addition, in a case where a plurality of external terminals form a certain structure and the structure accommodates a battery assembly, the connection members may facilitate electrical connection between the structure and the battery assembly. This is described in detail with reference to FIG. 9.

FIG. 9 illustrates a configuration in which a plurality of battery assemblies 910_1 to 910_3 are connected in parallel according to one or more embodiments of the present disclosure. The battery assemblies 910_1 to 910_3 may be connected in parallel with each other by using a positive electrode line 930 and a plurality of negative electrode lines 920_1 to 920_4. Depending on the polarity of the battery cells and the electrical polarity of the connection member of the protection circuit module, the electrical polarity of the positive electrode line 930 and the negative electrode lines 920_1 to 920_4 may be changed with each other. In FIG. 9, the battery assemblies 910_1 to 910_3 are shown as being connected in parallel, but the battery assemblies may be connected in series with each other.

Referring to FIG. 9, one positive electrode line 930 is shown, but a plurality of positive electrode lines may be formed. The negative electrode lines 920_1 to 920_4 are shown as four lines, but less than four lines or more than four lines may be provided. Although three battery assemblies 910_1 to 910_3 are shown, less than three battery assemblies or more than three battery assemblies may be provided. Although each of the battery assemblies 910_1 to 910_3 is shown as including four connection portions, each of the battery assemblies 910_1 to 910_3 may include less than four connection members or more than four connection members.

The positive electrode line 930 may be connected to the protection circuit modules 912_1 to 912_3 of each of the battery assemblies. For example, the 1_2 connection member (e.g., the 1_2 connection member 242 of FIG. 2) of the first protection circuit module 912_1 and the positive electrode line 930 may be connected. Similarly, the 1_2 connection member of the second protection circuit module 912_2 and the 1_2 connection member of the third protection circuit module 912_3 may be connected to the positive electrode line 930.

Each of the negative electrode lines 920_1 to 920_4 may be connected to the connection portions of the battery assemblies. For example, the first negative electrode line 920_1 may be connected to the first connection member of the first battery assembly 910_1, the first connection member of the second battery assembly 910_2, and the first connection member of the third battery assembly 910_3. Similarly, the second negative electrode line 920_2 may be connected to the second connection members of the battery assemblies 910_1 to 910_3, the third negative electrode line 920_3 may be connected to the third connection members of the battery assemblies 910_1 to 910_3, and the fourth negative electrode line 920_4 may be connected to the fourth connection members of the battery assemblies 910_1 to 910_3.

That is, the first battery assembly 910_1 may be connected to at least one of the negative electrode lines 920_1 to 920_4 and the positive electrode line 930 to form an electrical path. Similarly, the second battery assembly 910_2 may be connected to at least one of the negative electrode lines 920_1 to 920_4 and the positive electrode line 930 to form an electrical path. The third battery assembly 910_3 may be connected to at least one of the negative electrode lines 920_1 to 920_4 and the positive electrode line 930 to form an electrical path.

In one or more embodiments, the positive electrode line 930 and the negative electrode lines 920_1 to 920_4 may form a certain structure. The certain structure may accommodate the battery assemblies 910_1 to 910_3 and form an electrical path in which the battery assemblies 910_1 to 910_3 are connected. As described above, the electrical path may be formed with the certain structure for accommodating the battery assemblies 910_1 to 910_3 without a configuration for forming a separate electrical path.

Although the present disclosure has been described above with respect to embodiments thereof, the present disclosure is not limited thereto. Various modifications and variations can be made thereto by those skilled in the art within the scope of the present disclosure and the equivalent scope of the appended claims.

### DESCRIPTION OF SOME REFERENCE SYMBOLS

100: battery cell
111a: first electrode tab
112a: second electrode tab
115: film portion
120: case
122: joining line

## Claims

1. A protection circuit module (200) comprising:
a first substrate 210 on which a first-first connection member (220) connected to a first electrode terminal 134 of a battery cell (100, 410) and a second connection member (230) connected to a second electrode terminal (132) of the battery cell (100, 410) are located; and
a second substrate (240) connected to the first substrate (210), on which a first-second connection member (242) is located,
wherein the second substrate (240) is electrically connected to the first-first connection member (220) from among the first-first connection member (220) and the second connection member (230).

2. The protection circuit module (200) as claimed in claim 1, wherein the second substrate (240) is a flexible printed circuit board, FPCB.

3. The protection circuit module (200) as claimed in claim 1 or 2, further comprising a connection circuit (460) configured to connect the first-first connection member (220) and the first-second connection member (242).

4. The protection circuit module (200) as claimed in claim 3, wherein the connection circuit (460) configured to connect the first-first connection member (220) and the first-second connection member (242) is located on the first substrate (210) and the second substrate (240).

5. The protection circuit module (200) as claimed in claims 1 to 4, wherein one end of opposite ends of the second substrate (240) is connected to the first substrate (210), and the first-second connection member (242) is located at another end of opposite ends of the second substrate (240).

6. The protection circuit module (200) as claimed in claims 1 to 5, wherein the first-first connection member (220) is connected to the first electrode terminal (134) of the battery cell (100), and
wherein the first-second connection member (242), electrically connected to the first-first connection member (220) is connected to an external terminal (440, 450) having a same polarity as the first electrode terminal (134).

7. The protection circuit module (200) as claimed in claims 1 to 6, further comprising a protection circuit (420, 430) located on the first substrate (210),
wherein the protection circuit (420, 430) is electrically connected to the first-first connection member (220) and the second connection member (230) and is located on the first substrate (210).

8. The protection circuit module (200) as claimed in claim 7, further comprising a connection circuit (460) configured to connect the first-first connection member (220) and the first-second connection member (242) and comprising a relay (422, 432) and an electric resistor (424, 434) located between the first-first connection member (220) and the first-second connection member (242),
wherein the protection circuit (420, 430) is configured to control the relay (422, 432) and sense a current of the electric resistor (424, 434).

9. The protection circuit module (200) as claimed in claim 7, further comprising a connection circuit (460) configured to connect the first-first connection member (220) and the first-second connection member (242) and comprising a first relay (422), a second relay (432), a first electric resistor (424), and a second electric resistor (434) located between the first-first connection member (220) and the first-second connection member (242),
wherein the protection circuit comprises a first protection circuit (420) and a second protection circuit (430),
wherein the first protection circuit (420) is configured to control the first relay (422) and sense a current of the first electric resistor (424), and
wherein the second protection circuit (430) is configured to control the second relay (432) and sense a current of the second electric resistor (434).

10. A battery assembly (300, 500, 600, 700, 800) comprising:
a battery cell (100, 410) comprising an electrode assembly comprising a first electrode and a second electrode, a first electrode terminal (134) connected to the first electrode, a second electrode terminal (132) connected to the second electrode, and a case (120) configured to accommodate the electrode assembly and connected to the second electrode; and
a protection circuit module (200) comprising a first substrate (210) and a second substrate (240) connected to the first substrate (210),
wherein a first-first connection member (220) connected to the first electrode terminal (134) and a second connection member (230) connected to the second electrode terminal (132) are located on the first substrate (210), and
wherein the second substrate (240) is electrically connected to the first-first connection member (220) from among the first-first connection member (220) and the second connection member (230).

11. The battery assembly (300, 500, 600, 700, 800) as claimed in claim 10, wherein an external terminal (440, 450) having a different polarity from the first electrode is electrically connected to the case (120).

12. The battery assembly (300, 500, 600, 700, 800) as claimed in claim 10 or 11, further comprising connection members (610, 710_1, 710_2, 710_3, 810_1, 810_2, 810_3, 810_4) located on a surface of the case (120) and comprise a conductive material.

13. The battery assembly (300, 500, 600, 700, 800) as claimed in claim 12, wherein the connection members (610) are formed integrally with the case (120).

14. The battery assembly (300, 500, 600, 700, 800) as claimed in claim 12 or 13, wherein the connection members (610) are located on other surface of the case (120) except for one surface of the case (120) on which the first electrode terminal 134 is located.

15. An electronic device comprising the battery assembly (300, 500, 600, 700, 800) as claimed in claims 10 to 14.
